Europäisches Patentamt

European Patent Office

Office européen des brevets

(11) Numéro de publication: **0 021 907**
**B1**

(12) **FASCICULE DE BREVET EUROPEEN**

(45) Date de publication du fascicule du brevet: **13.02.85**

(51) Int. Cl.⁴: **H 01 L 27/02, H 01 L 23/56**

(21) Numéro de dépôt: **80400785.4**

(22) Date de dépôt: **03.06.80**

(54) Dispositif et procédé pour la réduction des réactions thermiques dans les circuits intégrés monolithiques.

(30) Priorité: **12.06.79 FR 7914992**

(43) Date de publication de la demande:
**07.01.81 Bulletin 81/01**

(45) Mention de la délivrance du brevet:
**13.02.85 Bulletin 85/07**

(84) Etats contractants désignés:
**DE GB IT NL**

(56) Documents cités:
**DE-A-1 439 617**
**GB-A-1 021 206**
**US-A-3 226 564**
**US-A-3 418 592**

**ELECTRONICS, vol. 37, 27 juillet 1964, NEW YORK (US), W.T. MATZEN et al.: "Low-frequency integrated circuits achieved with thermal transfer"**

(73) Titulaire: **THOMSON-CSF**
**173, Boulevard Haussmann**
**F-75379 Paris Cedex 08 (FR)**

(72) Inventeur: **Moreau, Jean-Michel**
**"THOMSON-CSF" SCPI 173, Bld Haussmann**
**F-75360 Paris Cedex 08 (FR)**

(74) Mandataire: **de Beaumont, Michel et al**
**THOMSON-CSF SCPI 173, Bld Haussmann**
**F-75379 Paris Cedex 08 (FR)**

Courier Press, Leamington Spa, England.

## Description

La présente invention concerne un dispositif et un procédé, pour la réduction des réactions thermiques dans les circuits intégrés monolithiques.

Il est de pratique courante, en technique électronique, de réaliser par l'intégration monolithique, c'est-à-dire sur un cristal de semiconducteur unique, des dispositifs complexes dont certaines parties sont amenées à dissiper des quantités de chaleur élevées. Il est fréquent en outre, que d'autres parties du circuit, qui dissipent des puissances calorifiques plus faibles, soient sensibles à la température. Dans ce cas, le fonctionnement du circuit se trouve perturbé. Cette réaction thermique peut limiter les performances des dispositifs réalisés par l'intégration monolithique, et il est donc important de pouvoir l'éliminer. En outre, les quantités de chaleur dissipée dans certains éléments peuvent être très variables dans le temps, de sorte que le circuit entier est soumis à des chocs thermiques préjudiciables à une bonne fiabilité du dispositif.

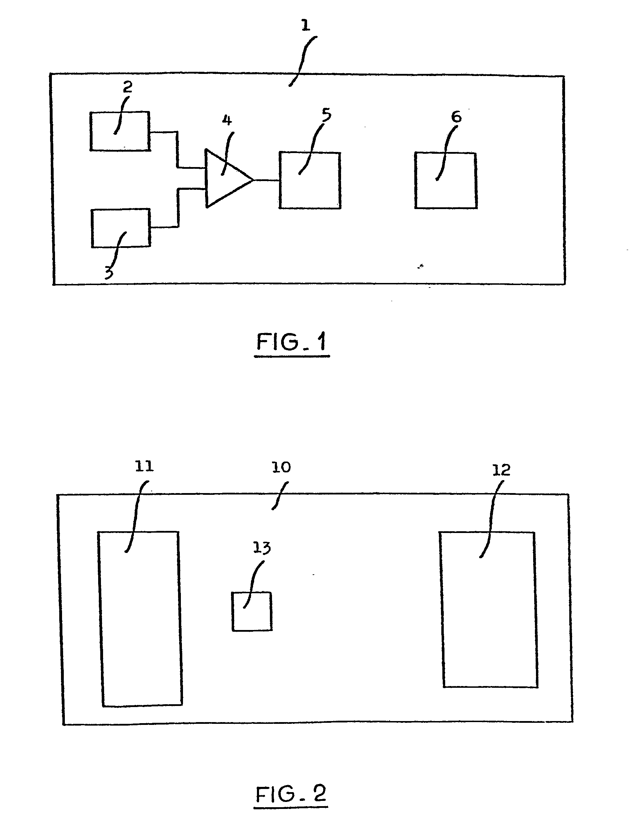

Un procédé connu pour obtenir une diminution des réactions thermiques dans de tels circuits intégrés monolithiques consiste à réaliser en même temps que le dispositif, et sur le même cristal de semiconducteur, un régulateur de température. Un dispositif mettant en oeuvre ce procédé est schématisé en figure 1. Sur le cristal de semiconducteur 1, sont implantés un élément ou sous-ensemble 2 servant de sonde thermométrique, un sous-ensemble 3 dont la sortie constitue la valeur de consigne, et un amplificateur 4 comparant les valeurs données par la sonde thermométrique et par la consigne et commandant un élément 5 capable de dissiper de la puissance thermique. La zone 6 schématise l'ensemble des dispositifs dissipateurs de puissance thermique variable dont les effets sur le reste du cristal semiconducteur sont perturbateurs. Dans un tel dispositif, l'amplificateur 4 réagit de telle manière que la température du cristal 1 soit maintenue sensiblement constante lorsque la puissance dissipée dans la zone 6 varie. Pour cela, lorsque la puissance dissipée dans la zone 6 augmente, la température du cristal tend à augmenter, ce qui provoque une diminution de la puissance dissipée par l'élément 5, qui rétablit l'équilibre thermique. En d'autre termes, la puissance totale dissipée par les zones 5 et 6 est sensiblement constante. Des documents typiques de cet état de la technique sont constitués par le brevet britannique 1 021 206 et par l'article de Matzen et Meadows paru dans "Electronics", 27 juillet 1964.

Ce procédé, qui permet de supprimer la réaction thermique, présente cependant certains inconvénients: l'ensemble du cristal doit être maintenu en permanence à la température la plus élevée qu'aurait pu atteindre occasionnellement le dispositif dans la zone 6 seule, ce qui est néfaste pour la fiabilité. De plus, l'ensemble des zones 5 et 6 doit dissiper en permanence la puissance maximale que la zone 6 aurait pu être amenée à dissiper seule, ce qui produit une consommation d'énergie élevée.

Dans de nombreux circuits, il n'est pas nécessaire que la température reste constante dans le cristal de semiconducteur pour éliminer les effets de la réaction thermique. En particulier, il peut être suffisant, pour de nombreuses applications, de supprimer l'effet des chocs thermiques en réduisant la vitesse de variation de la température et non son amplitude maximale. De même, dans le cas des amplificateurs pour audiofréquences, où la puissance dissipée par l'étage de sortie peut influer sur les étages d'entrée, le signal parasite qui en résulte n'est pas gênant si sa fréquence est suffisamment faible pour être inaudible.

La présente invention concerne de tels dispositifs, dans lesquels seules les variations brusques de température sont gênantes. Elle prévoit un dispositif pour éliminer ces variations brutales de température, qui permet en outre de consommer moins de puissance et de produire une température moins élevée que les dispositifs précédemment décrits.

Pour atteindre ces objets ainsi que d'autres, la présente invention prévoit un dispositif pour la réduction des vitesses de variation de température dans un substrat semiconducteur de circuit de intégré monolithique conducteur de la chaleur, comprenant dans le substrat des moyens sensibles à la température du substrat, des moyens produisant de la chaleur dans le substrat, et des moyens de commande reliant électriquement les moyens sensibles à la température aux moyens produisant de la chaleur de façon à amener ces derniers à modifier la quantité de chaleur produite, ladite modification ayant lieu en sens inverse des variations de température. Les moyens de commande font varier la quantité de chaleur produite seulement pendant la durée des variations de température et ramènent la quantité de chaleur produite à un niveau constant quand la température est stable, ce niveau constant étant indépendant de la valeur de cette température stable.

Selon un autre aspect de l'invention, les moyens de commande et de captage de température comprennent un transistor bipolaire en contact thermique avec le cristal de semiconducteur, et un condensateur branché entre la base et l'émetteur dudit transistor.

Selon un autre aspect de l'invention, il est prévu que l'ensemble des éléments du circuit sauf la source d'alimentation et le condensateur, soit réalisé sous forme intégrée sur le même cristal de semiconducteur.

Selon un autre aspect de la présente invention, dans un cristal monolithique conducteur de chaleur comprenant une première zone à protéger et une seconde zone émettrice d'énergie calorifique perturbatrice, il est prévu de disposer entre la zone à protéger et la zone émettrice au moins un dispositif selon l'invention.

Ces objets, caractéristiques et avantages ainsi que d'autres de la présente invention seront exposés plus en détail dans la description suivante de modes de réalisation particuliers, faite en relation avec les figures jointes parmi lesquelles:

— la figure 1 est destinée à illustrer un dispositif de l'art antérieur;
— la figure 2 représente schématiquement la disposition du dispositif selon l'invention placé entre les zones à protéger et les zones productrices d'énergie perturbatrice;
— la figure 3 représente le circuit selon l'invention; et
— la figure 4 représente des formes d'ondes destinées à servir de support à la description du fonctionnement du circuit selon la présente invention.

La figure 2 représente la disposition des différentes zones sur le cristal semiconducteur. Sur un même cristal 10, on a représenté une première zone 11, constituée par les éléments du dispositif que l'on doit protéger contre les variations brusques de température. La zone 12 correspond aux éléments dissipateurs d'énergie perturbatrice qui émettent une énergie calorifique variable. Cette énergie se propage avec une certaine vitesse dans le cristal 10 en direction de la zone 11 à protéger. On dispose au voisinage de cette zone 11, et du côté de la zone 12, le dispositif selon l'invention schématiquement représenté par la zone 13, dont le rôle est de compenser les variations rapides de puissance thermique transmises à la zone 11. De façon à réaliser une compensation qui soit toujours en phase avec les variations de la puissance émise par la zone 12, il est essentiel de placer cette zone 13 entre la zone émettrice et la zone à protéger.

Le dispositif de la zone 13 est constitué notamment d'un sous-ensemble dissipateur d'énergie commandé par un sous-ensemble de commande qui, en fonction de la température de la zone mesurée par des moyens sensibles à la température, forcent à court terme l'état du sous-ensemble dissipateur de façon à compenser momentanément les variations de cette température. L'action des moyens de commande n'est effective que pendant une durée brève et prédéterminée, c'est-à-dire que la compensation de température ne se poursuit pas au-delà de cette durée. Ainsi, si la zone 12 est le siège d'une pointe de dissipation thermique de courte durée, le dispositif de la zone 13 réagit en diminuant pendant cette même courte durée l'énergie dissipée par son sous-ensemble dissipateur. Par contre, si l'énergie émise par le zone 12, en partant d'un certain niveau moyen, augmente lentement et s'établit à un niveau moyen plus élevé, le dispositif de la zone 13 n'oppose aucune réaction,

l'énergie dissipée par le sous-ensemble dissipateur est la même avant et après la modification.

Cette disposition permet de réaliser une compensation efficace des effets des variations rapides de puissance perturbatrice sans nécessiter une dissipation calorifique importante dans la zone 13. En effet, les éléments dissipateurs de cette zone sont amenés à dissiper en régime continu une puissance au plus égale à la valeur de crête de la variation de puissance émise par la zone 12. Plus exactement, le dispositif 13 peut ne compenser que la valeur crête de la variation de puissance, émise par la zone 12, qui transite au voisinage de la zone 13 vers la zone à protéger 11. Du fait de l'éloignement relatif des zones 12 et 13, cette valeur crête de puissance à compenser est plus faible. Ainsi, un dispositif de l'art antérieur tel que celui de la figure 1 nécessite une dissipation de l'élément régulateur au moins égale à la valeur crête-crête de la variation de puissance de la zone perturbatrice, alors que le dispositif selon la présente invention permet une compensation efficace tout en ne dissipant qu'une fraction de la valeur crête de la variation de puissance de la zone perturbatrice.

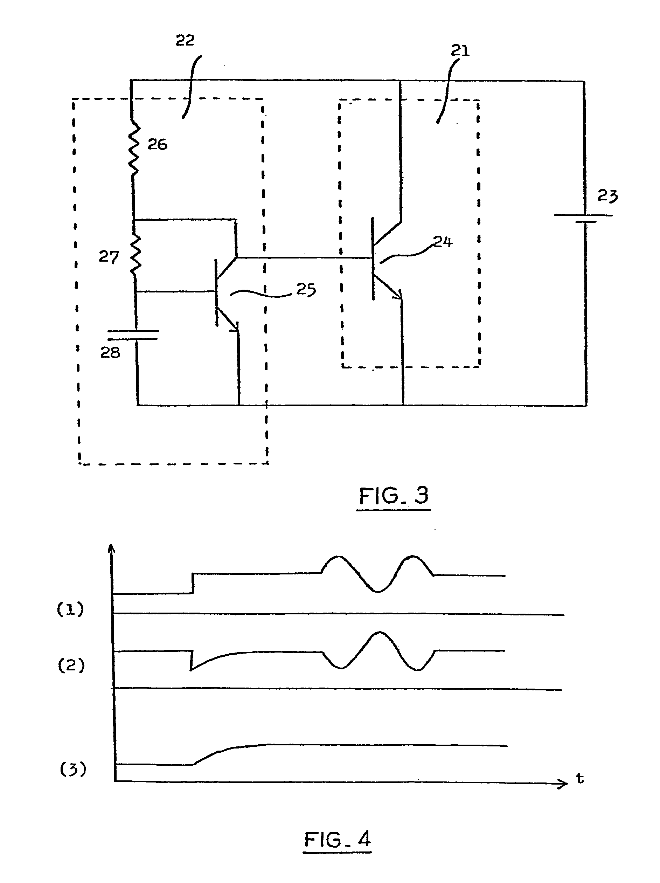

La figure 3 représente en détail le dispositif qui est placé dans la zone 13 de la figure 2. Ce dispositif comprend un sous-ensemble 21 dissipateur d'énergie, commandé par un sous-ensemble 22 dont le rôle est de commander suivant la température du cristal semiconducteur la puissance dissipée par l'ensemble 21, et une source d'alimentation 23.

Selon le mode de réalisation représenté, l'élément de dissipation thermique 21 est constitué d'un transistor à jonction bipolaire 24 de type NPN, dont l'émetteur est relié à la borne négative de la source d'alimentation 23 et le collecteur est relié à la borne positive de la même source. Le sous-ensemble de commande 22 est constitué d'un second transistor 25 de type NPN, dont l'émetteur est relié à la borne négative de la source d'alimentation 23, dont le collecteur est relié à la borne positive de la source d'alimentation 23 par l'intermédiaire d'une résistance de forte valeur 26, et dont la base est reliée au collecteur par l'intermédiaire d'une résistance 27. Une capacité 28 est en outre connectée entre la base et l'émetteur de ce transistor. Le collecteur du transistor 25 est connecté à la base du transistor dissipateur d'énergie 24.

Le fonctionnement de ce circuit est le suivant:

En régime établi, c'est-à-dire en l'absence de perturbations en provenance des zones productrices d'énergie calorifique variable, presque tout le courant traversant la résistance 26 traverse le transistor 25. Le collecteur de ce dernier est donc à un potentiel un peu plus élevé que sa base. En conséquence, le transistor 24 est conducteur et dissipe une certaine puissance.

Si la puissance dissipée par la zone 12 de la figure 2 augmente rapidement, sa température augmente. Cette augmentation se propage dans tout le cristal de semiconducteur et atteint la zone 13 et le transistor 25. La tension entre base et émetteur de ce transistor est maintenue presque constante à court terme par le condensateur 28. Or il est bien connu qu'un transistor bipolaire maintenu dans ces conditions voit sa tension émetteur collecteur diminuer rapidement. Ainsi, le transistor 25, sous l'effet de l'augmentation de température, réagit de façon à ce que la tension entre son émetteur et son collecteur diminue rapidement. Par conséquent, la différence de potentiel entre la base et l'émetteur du transistor 24 diminue, ce qui entraîne une réduction du courant collecteur du transistor 24 et de la puissance thermique dissipée dans ce transistor.

Si au contraire la dissipation thermique de la zone 12 diminuait, la dissipation de la zone 24 augmenterait en même temps, ayant pour effet de maintenir faible à court terme la variation de température du transistor 25. L'effet régulateur du dispositif est maintenu pendant un temps qui dépend de la valeur de la capacité 28. En effet, aux bornes de cette capacité, la tension ne peut varier instantanément. Le transistor 25 est donc polarisé entre base et émetteur par une tension momentanément constante, tant que la charge de la capacité 28 n'a pas varié. Ainsi, dans le cas d'une réaction du dispositif à une augmentation de la puissance perturbatrice, le courant traversant le collecteur du transistor 25 a tendance à augmenter, ainsi que son courant de base. Ce courant provient de la résistance 26 de forte valeur en série avec la tension d'alimentation 23 qui agissent comme une source de courant. Cela provoque une décharge progressive de la capacité 28. Au cours de cette décharge, le dispositif revient progressivement à son état de départ, c'est-à-dire que le courant traversant le transistor 25 est de nouveau voisin du courant fourni par la source de courant formée par les éléments 26 et 23, et la puissance dissipée dans le transistor 24 est ramenée à son niveau initial. Le dispositif selon la présente invention permet ainsi de compenser les variations rapides de puissance dissipée, cette compensation étant limitée dans le temps. Lorsque la zone perturbatrice 12 émet des perturbations successives, par exemple de formes sinusoïdales, le dispositif est capable de compenser ces variations sinusoïdales car la capacité 28 se charge et se décharge au rythme de ces variations.

Le fonctionnement du circuit de la présente invention est illustré à la figure 4 sur laquelle la courbe (1) représente les variations de puissance calorifique présentes au voisinage de la zone 13 et provenant de la zone perturbatrice 12. On a représenté d'une part un échelon positif de puissance, et d'autre part une suite sinusoïdale de variations de cette puissance. La courbe (2) représente les variations instantanées de puissance dissipée par le transistor 24 en réponse aux variations de puissance de la courbe (1). On remarque en particulier que les variations de puissance sinusoïdales de la zone 12 donnent lieu à des variations de puissance sinusoïdales en phase opposée du transistor 24 de manière que la somme instantanée de ces deux puissances soit sensiblement constante. Sur la courbe (3), on a représenté la température au voisinage de la zone 13; l'échelon de puissance donne lieu à une réponse en température d'allure exponentielle qui se stabilise au bout d'un certain temps à une température plus élevée. Par contre les variations sinusoïdales rapides de puissance ne donnent lieu à aucune variation de température. Ainsi, la zone 11 à protéger ne subit pas de variation rapide de sa température.

Dans les applications de circuit intégré monolithique, un tel dispositif peut être réalisé sous forme d'éléments intégrés dans le cristal de semiconducteur, la capacité 28 et la source d'alimentation 23 pouvant être maintenues extérieures au circuit intégré.

La présente invention décrite selon un mode de réalisation particulier, est susceptible de variantes. Par example, la source de courant constituée par la résistance 26 en série avec la source d'alimentation 23 peut être constituée par tout autre moyen bien connu dans la technique des circuits intégrés.

**Revendications**

1. Dispositif pour la réduction des vitesses de variation de température dans un substrat semiconducteur de circuit intégré monolithique conducteur de la chaleur, comprenant dans le substrat des moyens sensibles à la température du substrat, des moyens produisant de la chaleur dans le substrat, et des moyens de commande reliant électriquement les moyens sensibles à la température aux moyens produisant de la chaleur de façon à amener ces derniers à modifier la quantité de chaleur produite, ladite modification ayant lieu en sens inverse des variations de température, caractérisé en ce que les moyens de commande font varier la quantité de chaleur produite seulement pendant la durée des variations de température et ramènent la quantité de chaleur produite à un niveau constant quand la température est stable, ce niveau constant étant indépendant de la valeur de cette température stable.

2. Dispositif selon la revendication 1, caractérisé en ce que l'ensemble formé par les moyens de commande et les moyens sensibles à la température comprend un transistor de type bipolaire à jonction intégré dans le substrat et un condensateur branché entre la base et l'émetteur dudit transistor.

3. Dispositif selon la revendication 2, caractérisé en ce que le transistor de commande est polarisé entre son émetteur et son collecteur par une source de courant.

4. Dispositif selon la revendication 3, caractérisé en ce que la source de courant est réalisée par une résistance de forte valeur en série avec la source de tension de polarisation du transistor bipolaire de production de chaleur.

5. Dispositif selon l'une quelconque des revendications 2 à 4, caractérisé en ce que l'émetteur du transistor de production de chaleur relié à l'émetteur du transistor de commande, et en ce que le collecteur du transistor de commande est relié à la base du transistor de production de chaleur.

6. Réalisation du dispositif selon l'une des revendications 1 à 5, pour la réduction des réactions thermiques dans un substrat semiconducteur de circuit intégré monolithique conducteur de la chaleur comprenant une zone à protéger et une zone émettrice d'énergie calorifique, dans laquelle ledit dispositif est disposé entre la zone à protéger et la zone perturbatrice et émettrice.

## Patentansprüche

1. Vorrichtung zur Reduzierung der Temperatur-Änderungsgeschwindigkeiten in einem Halbleitersubstrat einer wärmeleitenden monolithischen integrierten Schaltung, mit auf die Temperatur des Substrates ansprechenden Mitteln in dem Substrat, Mitteln, welche in dem Substrat Wärme erzeugen, und Steuermitteln, welche die temperaturempfindlichen Mittel elektrisch mit den wärmeerzeugenden Mitteln verbinden, so daß diese die Menge der erzeugten Wärme verändern, wobei die genannte Änderung in entgegensetztem Sinne wie die Temperaturänderungen erfolgt, dadurch gekennzeichnet, daß die Steuermittel die Menge der erzeugten Wärme nur während der Dauer der Temperaturänderungen verändern und die Menge der erzeugten Wärme auf einen konstanten Pegel zurückbringen, wenn die Temperatur stabil ist, wobei dieser konstante Pegel unabhängig von dem Wert dieser stabilen Temperatur ist.

2. Vorrichtung nach Anspruch 1, dadurch gekennzeichnet, daß die durch die Steuermittel und die temperaturempfindlichen Mittel gebildete Einheit einen Transistor vom bipolaren Typ mit in das Substrate integriertem Übergang und einen Kondensator umfaßt, welcher zwischen die Basis und den Emitter dieses Transistor geschaltet ist.

3. Vorrichtung nach Anspruch 2, dadurch gekennzeichnet, daß der Steuertransistor zwischen seinem Emitter und seinem Kollektor durch eine Stromquelle polarisiert wird.

4. Vorrichtung nach Anspruch 3, dadurch gekennzeichnet, daß die Stromquelle durch einen Widerstand von hohem Wert in Reihe mit der Spannungsquelle zur Polarisation des bipolaren, wärmeerzeugenden Transistors verwirklicht ist.

5. Vorrichtung nach einem der Ansprüche 2 bis 3, dadurch gekennzeichnet, daß der Emitter des wärmeerzeugenden Transistors mit dem Emitter des Steuertransistors verbunden ist und daß der Kollektor des Steuertransistors mit der Basis des wärmeerzeugenden Transistors verbunden ist.

6. Ausführung der Vorrichtung nach einem der Ansprüche 1 bis 5, zur Verminderung der thermischen Reaktionen in einem Halbleitersubstrat einer wärmeleitenden monolitischen integrierten Schaltung, die eine zu schützende Zone und eine Wärme aussendende Zone umfaßt, wobei die genannte Vorrichtung zwischen der zu schützenden Zone und der störenden, Wärme abgebenden Zone angeordnet ist.

## Claims

1. Device for the reduction of the temperature variation speeds within a semiconductor substrate of a thermally conducting monolithic integrated circuit, comprising within the substrate means responding to the temperature of the substrate, means producing heat within the substrate and control means electrically connecting the temperature-responsive means to the heat-producing means in a manner to cause the latter to modify the quantity of heat produced, said modification being produced in a sense opposite to that of the temperature variations, characterized in that the control means cause the quantity of produced heat to vary only during the duration of the temperature variations and to restore the quantity of heat produced to a constant level when the temperature is stable, this constant level being independent of the value of this stable temperature.

2. Device according to claim 1, characterized in that the unit formed of the control means and the temperature-responsive means comprises a transistor of bipolar type having a junction integrated into the substrate and a capacitor connected between the base and the emitter of said transistor.

3. Device according to claim 2, characterized in that the control transistor is polarized by a current source between its emitter and its collector.

4. Device according to claim 3, characterized in that the current source is formed of a resistor having a high value and connected in series with the voltage source for the polarization of the bipolar heat producing transistor.

5. Device according to any of claims 2 to 4, characterized in that the emitter of the heat producing transistor is connected to the emitter of the control transistor and in that the collector of the control transistor is connected to the base of the heat producing transistor.

6. Embodiment of the device according to any of claims 1 to 5 for the reduction of the thermal reactions in a semiconductor substrate of a thermally conductive monolithic integrated circuit comprising a zone to be protected and a zone emitting heat energy, wherein said device is located between the zone to be protected and the disturbing emitting zone.

FIG. 1

FIG. 2

FIG. 3

FIG. 4